(19) Europäisches Patentamt
European Patent Office
Office européen des brevets

(11) **EP 1 110 324 B1**

(12) **EUROPÄISCHE PATENTSCHRIFT**

(45) Veröffentlichungstag und Bekanntmachung des Hinweises auf die Patenterteilung:
**27.11.2002 Patentblatt 2002/48**

(21) Anmeldenummer: **99952267.5**

(22) Anmeldetag: **02.08.1999**

(51) Int Cl.⁷: $H03K\ 23/68$, $H03K\ 23/66$

(86) Internationale Anmeldenummer:
**PCT/DE99/02409**

(87) Internationale Veröffentlichungsnummer:
**WO 00/008761 (17.02.2000 Gazette 2000/07)**

(54) **RATIONALER FREQUENZTEILER**

RATIONAL FREQUENCY DIVIDER

DIVISEUR DE FREQUENCE RATIONNEL

(84) Benannte Vertragsstaaten:
**DE ES FR GB**

(30) Priorität: **06.08.1998 DE 19835640**

(43) Veröffentlichungstag der Anmeldung:
**27.06.2001 Patentblatt 2001/26**

(73) Patentinhaber: **SIEMENS AKTIENGESELLSCHAFT 80333 München (DE)**

(72) Erfinder:
• **SCHNABEL, Dirk D-81369 München (DE)**
• **QUIRMBACH, Gerhard D-80689 München (DE)**

(56) Entgegenhaltungen:
EP-A- 0 351 212   US-A- 3 824 378
US-A- 4 084 082   US-A- 4 296 407

• **PATENT ABSTRACTS OF JAPAN vol. 006, no. 077 (E-106), 14. Mai 1982 (1982-05-14) & JP 57 015536 A (NEC CORP), 26. Januar 1982 (1982-01-26)**

## Beschreibung

Die vorliegende Erfindung betrifft einen rationalen Frequenzteiler zur Erzeugung einer ganzzahligen Frequenz aus einer rationalen Frequenz.

Derzeit häufig verwendete Prozessoren wie der Pentium und der Pentium-II von Intel oder der K6 von AMD benötigen für die Bedienung der Systembusse (Speicher, PCI) eine rationale Frequenz (beispielsweise von 200/3 MHz = $6,\bar{6}$ MHz. Durch eine derartige Frequenzwahl erzielt man ganzzahlige Speicherzyklus-Zeiten (15 ns bei $6,\bar{6}$ MHz; 30 ns bei $3,\bar{3}$ MHz). Eine Abweichung beispielsweise von der rationalen Frequenz $6,\bar{6}$ MHz auf die ganzzahlige Frequenz 66,0 oder 67,0 MHz ist dabei nicht zulässig, da in diesem Fall die Funktion der Prozessoren nicht sichergestellt werden kann.

Für andere Funktionen wie beispielsweise den Betrieb einer Echtzeituhr oder die Berechnung von Gebührendaten bei Vermittlungssystemen werden jedoch ganzzahlige Frequenzen erforderlich.

Zur Erzielung einer ganzzahligen Frequenz wird herkömmlicherweise ein Quarz-Generator verwendet, der Schwingungen einer ganzzahligen Frequenz erzeugt. Nachteilig dabei ist jedoch das Entstehen einer schlecht zu bedienenden asynchronen Schnittstelle.

Des weiteren ist es bekannt, zur Erzielung einer ganzzahligen Frequenz die rationale Prozessorfrequenz durch eine ganze Zahl, genauer gesagt durch eine natürliche Zahl, (z.B. durch 66 oder 67) zu teilen. Nachteilig ist dabei jedoch das Entstehen einer hohen Toleranz, aufgrunddessen die Echzeituhr häufig korrigiert werden muß und für jede Gebührenerfassung eine zusätzliche Korrektur erfordert wird.

Aus dem Patent US 5 714 896 ist ein Frequenzteiler zum Erzeugen einer ganzzahligen Frequenz aus einer rationalen Frequenz gemäß Oberbegriff des Patentanspruchs 1 bekannt. Der Frequenzteiler enthält einen Speicher zur Speicherung einer ersten Teilerkonstanten und einer zweiten Teilerkonstanten. Eine Wähleinrichtung dient zur Auswahl einer der beiden Teilerkonstanten. Ein erster Zähler ist in einem programmierbaren Frequenzteiler enthalten, der im Takt der Schwingung der rationalen Frequenz teilt. Außerdem enthält der Frequenzteiler einen Zähler, der an die Wähleinrichtung gekoppelt ist und eine Anzahl vorbestimmter Zeitschlitze zählt, in denen eine der beiden Teilerkonstanten verwendet wird. Ein weiterer Zähler ist ebenfalls mit der Wähleinrichtung gekoppelt und dient zum Zählen der Zeitschlitze in denen die andere Teilerkonstante verwendet wird. Es werden also drei Zähler verwendet, so dass der schaltungstechnische Aufwand vergleichsweise hoch ist. Außerdem muss eine Steuereinheit zwischen den Zählern für die Zeitschlitze umschalten.

Aus dem Artikel von P. Larsson, "A Wide -Range Programmable High-Speed CMOS Frequency Divider", IEEE Int. Symposium on Circuits and Systems', US, New York, 1995, ist ein Frequenzteiler zum Erzeugen einer ganzzahligen Frequenz aus einer rationalen Frequenz bekannt. Der Frequenzteiler enthält drei Zähler, von denen einer programmierbar ist und im Takt der Schwingungen der rationalen Frequenz zählt. Der programmierbare Teiler teilt abhängig von einer in einem Register gespeicherten Teilerkonstanten. Der programmierbare Teiler enthält außerdem eine Vergleichseinrichtung und wird von einer Steuereinheit angesteuert, die eine von zwei Teilerkonstanten auswählt.

Aus der Patentanmeldung JP 57 138221 A ist ein umschaltbarer Frequenzteiler bekannt, der gemäß einer Teilerkonstanten oder gemäß dem halben Wert der Teilerkonstanten teilt. Der Frequenzteiler enthält einen Zähler und ein Vergleichseinrichtung.

Aufgabe der Erfindung ist es daher, einen rationalen Frequenzteiler zu schaffen, bei welchem die oben beschriebenen Nachteile nicht auftreten, bzw. ein entsprechendes Verfahren vorzusehen.

Die Aufgabe wird gelöst durch die Merkmale der unabhängigen nebengeordneten Ansprüche.

Dementsprechend wird ein rationaler Frequenzteiler zur Erzeugung einer ganzzahligen Frequenz aus einer rationalen Frequenz bereitgestellt mit: einem Speicher zur Speicherung von ersten und zweiten Teilerkonstanten; einer Wähleinrichtung zur Auswahl einer der gespeicherten Teilerkonstanten; einem ersten Zähler, welcher im Takt der Schwingungen der rationalen Frequenz zählt; einer Vergleichseinrichtung, welche den Wert des ersten Zählers mit der gewählten Teilerkonstanten vergleicht; einem zweiten Zähler, welcher an die Wähleinrichtung und die Vergleichseinrichtung gekoppelt ist und eine Anzahl vorbestimmter Zeitschlitze zählt; und einer Impulserzeugungseinrichtung zur Bildung der ganzzahligen Frequenz durch Erzeugen eines Impulses im Ansprechen auf ein Signal der Vergleichseinrichtung. Durch die erfindungsgemäße Vorrichtung wird mit einem geringen Schaltungsaufwand ein rationaler Frequenzteiler bereitgestellt, der zur Erzeugung einer ganzzahligen Frequenz aus einer rationalen Frequenz geeignet ist.

Entsprechend einer bevorzugten Ausführungsform ist der erfindungsgemäße rationale Frequenzteiler derart ausgestaltet, daß er zur Erzeugung einer ganzzahligen Frequenz aus einer rationalen Frequenz entsprechend der Beziehung

$$f_g = \frac{f_0}{g^{z}/_n}$$

geeignet ist, wobei $f_g$ die ganzzahlige Frequenz, $f_0$ die rationale Frequenz, g eine erste Teilerkonstante, z einen Teilerkonstantenzähler und n die Anzahl von Zeitschlitzen darstellen und g, z und n natürliche Zahlen sind. Insbesondere weist der Speicher Bereiche zur Speicherung von n-z ersten und z zweiten Teilerkonstanten g bzw. g+1 auf; ist die Wähleinrichtung derart ausgebildet, daß während des Betriebs innerhalb eines Zyklus von n Zeitschlitzen die gespeicherten Teilerkonstanten jeweils einmal gewählt werden; ist der erste Zähler derart ausgebildet, daß er im Ansprechen auf ein Signal der Vergleichseinrichtung, welches die Gleichheit des Werts des ersten Zählers mit der gewählten Teilerkonstanten anzeigt, auf den Wert 1 zurückgesetzt wird; und ist der zweite Zähler derart ausgebildet, daß er im Ansprechen auf ein Signal der Vergleichseinrichtung, welches die Gleichheit des Werts des ersten Zählers mit der gewählten Teilerkonstanten anzeigt, um den Wert 1 erhöht und nach Erreichen des Werts von n auf 1 zurückgesetzt wird.

Darüber hinaus wird durch die vorliegende Erfindung ein Verfahren zur Erzeugung einer ganzzahligen Frequenz aus einer rationalen Frequenz geschaffen, mit den Schritten: a] Bestimmen und Abspeichern der Größen g, z, und n entsprechend der Beziehung $f_g = \frac{f_0}{z/n}$, wobei $f_g$ die ganzzahlige Frequenz, $f_0$ die rationale Frequenz, g eine erste Teilerkonstante, z einen Teilerkonstantenzähler und n die Anzahl von Zeitschlitzen darstellen und g, z und n natürliche Zahlen sind, und der Größe g+1, welche eine zweite Teilerkonstante darstellt; b] Initialisieren eines ersten Zählers, welcher im Takt der Schwingungen der rationalen Frequenz zählt, und eines zweiten Zählers, welcher die Zeitschlitze zählt, auf den Wert 1; c] Wählen der ersten oder zweiten Teilerkonstante; d] Zählen des ersten Zählers im Takt der Schwingungen der rationalen Frequenz; e] Erfassen der Gleichheit des Werts des ersten Zählers und der gewählten Teilerkonstante; f] Erzeugen eines Impulses auf das Erfassen der Gleichheit des Werts des ersten Zählers und der gewählten Teilerkonstante zur Bildung der ganzzahligen Frequenz; g] Rücksetzen des ersten Zählers auf den Wert 1; h] Erhöhen des zweiten Zählers um 1; i] Wiederholen der Schritte c] bis h], wobei während eines Zyklus von n Zeitschlitzen [n-z]-mal die erste Teilerkonstante und z-mal die zweite Teilerkonstante gewählt wird; und k] Rücksetzen des zweiten Zählers auf den Wert 1, nachdem der zweite Zähler den Wert von n erreicht hat und die Schritte c] bis g] n-mal ausgeführt worden sind. Jeweils unmittelbar nach dem n-ten Zeitschlitz besitzt die nach dem erfindungsgemäßen Verfahren erzeugte Schwingung die exakte vorbestimmte ganzzahlige Frequenz.

Die vorliegende Erfindung wird in der nachfolgenden Beschreibung unter Bezugnahme auf die Zeichnung erläutert.

Fig. 1 zeigt ein Diagramm, welches schematisch die Erzeugung einer ganzzahligen Frequenz aus einer rationalen Frequenz unter Verwendung des erfindungsgemäßen rationalen Frequenzteilers und eines ganzzahligen Teilers nach dem Stand der Technik darstellt;

Fig. 2 zeigt ein Blockschaltdiagramm des erfindungsgemäßen rationalen Teilers, welcher zur Frequenzteilung entsprechend der Beziehung $f_g = \frac{f_0}{g^{z/n}}$ geeignet ist;

Fig. 3 zeigt ein Blockschaltdiagramm des erfindungsgemäßen rationalen Teilers von Fig. 2 für den Spezialfall g=2, z=2 und n=3; und

Fig. 4 zeigt ein Impulsdiagamm des in Fig. 3 dargestellten erfindungsgemäßen rationalen Teilers.

Die Frequenzteilung wird sowohl im Hinblick auf den allgemeinen Fall, bei welchem eine beliebige rationale Frequenz durch geeignete Wahl einer rationalen Zahl r in eine beliebige ganzzahlige Frequenz geteilt wird, als auch für den Spezialfall beschrieben, bei welchem eine rationale Frequenz von $f_0$ = 200/3 MHz durch die rationale Zahl = $g^{z/n}$ = $2\,^2/_3$ in die ganzzahlige Frequenz $f_g = f_0/r$ = 25 MHz geteilt wird.

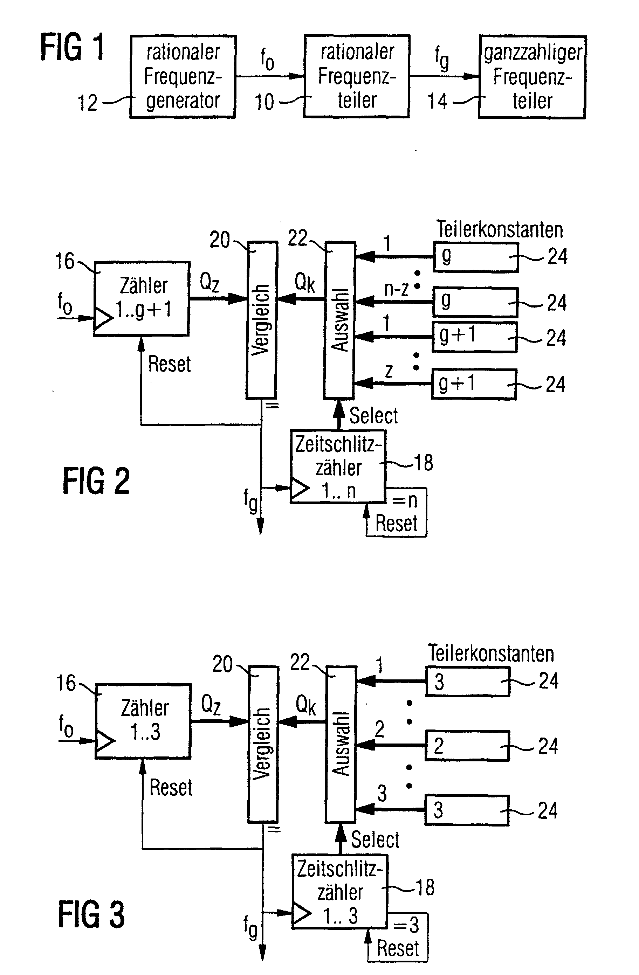

Gemäß Fig. 1 wird von einem rationalen Frequenzgenerator 12 eine Schwingung mit der rationalen Frequenz $f_0$ von beispielsweise 200/3 MHz erzeugt und von einem rationalen Frequenzteiler 10 durch eine rationale Zahl r = $2\,^2/_3$ in eine Schwingung mit der ganzzahligen Frequenz $f_g = \frac{200/3}{2\,^2/_3}$ MHz = 25 MHz geteilt. Die ganzzahlige Frequenz $f_g$ = 25 MHz kann anschließend mittels eines herkömmlichen ganzzahligen Frequenzteiler (14) durch eine ganze, genauer gesagt durch eine natürliche Zahl, weiter geteilt werden, und es ergibt sich beispielsweise bei einer Teilung durch 25 eine genaue Zeitbasis von 1 µs.

Der rationale Frequenzteiler ist dadurch bestimmt, daß nicht über den gesamten Zeitraum durch eine Teilerkonstante, sondern über n Zeitschlitzen durch jeweils eine von zwei Teilerkonstanten g bzw. g+1 geteilt wird. Durch g wird (n-z)-mal geteilt, während durch g+1 z-mal geteilt wird.

Die rationale Zahl r läßt sich somit wie folgt ersetzen: = $g^{z/n} = \frac{n-z}{n} \cdot g + \frac{z}{n}(g+1)$, d.h. im Falle g=2, z=2 und n=3 ergibt sich = $g^{z/n} = \frac{3-2}{3} \cdot 2 + \frac{2}{3} \cdot (2+1) = 2^2/_3$.

Darüber hinaus ist eine andere Festlegung der Teilerkonstanten sowie der Größen z und n zur Erzielung desselben Ergebnisses möglich, d.h. die Festlegung der Teilerkonstanten und der Größen z und n ist willkürlich.

Fig. 2 zeigt eine allgemeine Realisierung des rationalen Frequenzteilers. Dementsprechend bezeichnet Bezugszeichen 16 einen ersten Zähler, der an seinem Eingang mit dem rationalen Frequenzgenerator 12 und an seinem Ausgang mit einer Vergleichseinrichtung 20 verbunden ist. Der ersten Zähler 16 zählt im Takt der Schwingung mit der Frequenz $f_0$ eine Zahl QZ. Ein Speicher 24 bestehend aus n Speicherteilen zur Speicherung n-z erster und z zweiter Teilerkonstanten g bzw. g+1 ist an einen ersten Eingang einer Wähleinrichtung 22 angeschlossen, deren zweiter Eingang an einen zweiten Zähler (Zeitschlitzzähler, welcher in einem Zyklus n Zeitschlitze zählt) 18 und deren Ausgang an die Vergleichseinrichtung 20 angeschlossen sind. Eine nichtdargestellte Impulserzeugungseinrichtung, zur Erzeugung einer Schwingung mit der ganzzahligen Frequenz $f_g$ ist an die Vergleichseinrichtung 20 gekoppelt.

Fig. 3 stellt einen Spezialfall des rationalen Frequenzteilers von Fig. 2 dar, welcher zur Frequenzteilung mit der rationalen Zahl r = $2^2/_3$ (g=2, z=2, n=3) vorgesehen ist. Bei dieser Ausführungsform enthält der Speicher drei Speicherteile (gleich dem Wert von n), deren Inhalt 3 (g+1 zum ersten Mal), 2 (g) bzw. 3 (g+1 zum zweiten Mal) beträgt.

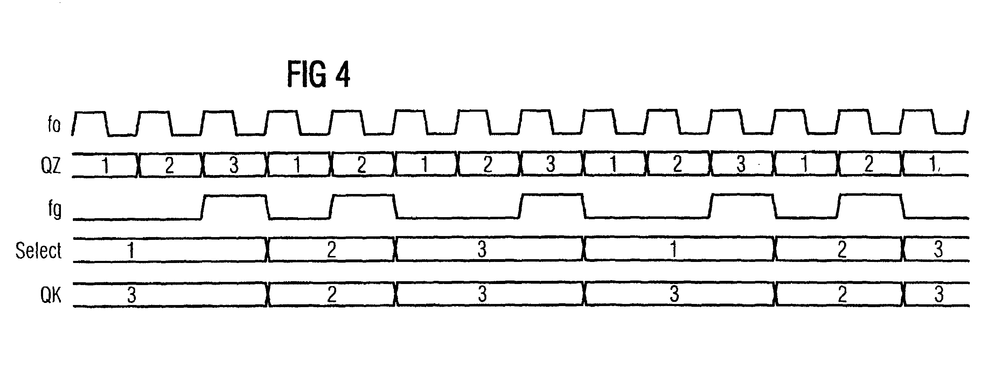

Im folgenden wird die Funktion des rationalen Frequenzteilers entsprechend der in Fig. 3 dargestellten Ausführungsform anhand des in Fig. 4 dargestellten Impulsdiagramms dargestellt. Es wird dabei eine Frequenzteilung entsprechend der Beziehung $f_g = \dfrac{f_0}{z/g'}$ dahingehend durchgeführt, daß zur Erlangung der ganzzahligen Frequenz die rationale Frequenz $f_0$ durch die rationale Zahl r = $2^2/_3$ (g=2, z=2, n=3) geteilt wird.

Der erste Zähler 16 zählt entsprechend dem Takt der ihm zugeführten rationalen Frequenz von 1 bis maximal g bzw. g+1 und führt diesen Wert als Größe QZ der Vergleichseinrichtung 20 zu. Ein Erreichen des Endwerts g bzw. g+1 (entsprechend einer unten beschriebenen gewählten Teilerkonstante) wird von der Vergleichseinrichtung 20 erfaßt, die daraufhin den Zähler 16 im nächsten Takt durch Anlegen eines Rücksetzsignals auf den Anfangswert zurücksetzt. Des weiteren veranlaßt die Vergleichseinrichtung 20 auf das Erreichen des Endwerts des ersten Zählers 16, daß der Zeitschlitzzähler 18 weiterzählt und durch die nichtdargestellte Impulserzeugungseinrichtung ein Impuls erzeugt wird, der die ganzzahlige Frequenz $f_g$ definiert.

Der Zeitschlitzzähler 18 zählt innerhalb eines Zyklus von 1 bis n, wobei n die Anzahl von vorbestimmten Zeitschlitzen ist, die benötigt wird, um genau eine ganzzahlige Frequenz zu erzeugen. In jedem der n Zeitschlitze wählt der Zeitschlitzzähler über die Wähleinrichtung 22 eine in den Teilspeichern des Speichers 24 gespeicherte Teilerkonstante g oder g+1 aus, die von der Wähleinrichtung an die Vergleichseinrichtung als Größe QK weitergeleitet wird. Während eines Zyklus, d. h. während n=3 Zeitschlitzen, wird die erste Teilerkonstante g einmal (n-z=3-2=1) und die zweite Teilerkonstante g+1 zweimal (z=2) gewählt. Hier werden der Reihe nach die Teilerkonstanten g+1=3 (Select=1), g=2 (Select=2) und g+1=3 (Select=3) gewählt und an die Vergleichseinrichtung 20 angelegt. Vorteilhaft wird mit der Wahl der Teilerkonstanten begonnen, die der rationalen Zahl r am nächsten liegt, um die Abweichung der augenblicklichen ganzzahligen Frequenz $f_g$ innerhalb eines nicht abgeschlossenen Zyklus von der genauen ganzzahligen Frequenz am Ende eines jeden Zyklus klein zu halten. Am Ende eines jeden Zeitschlitzes hat sich die augenblickliche ganzzahlige Frequenz $f_g$ weiter der genauen ganzzahligen Frequenz am Ende eines jeden Zyklus angenähert. Nach Durchführung des n-ten Arbeitstaktes wird der Zeitschlitzzähler auf den Wert 1 zurückgesetzt und mit der Durchführung des nächsten Zyklus begonnen.

## Patentansprüche

1. Rationaler Frequenzteiler zur Erzeugung einer ganzzahligen Frequenz ($f_g$) aus einer rationalen Frequenz ($f_0$), mit

   - einem Speicher (24) zur Speicherung von ersten und zweiten Teilerkonstanten (g bzw. g+1);
   - einer Wähleinrichtung (22) zur Auswahl einer der gespeicherten Teilerkonstanten;
   - einem ersten Zähler (16), welcher im Takt der Schwingungen der rationalen Frequenz zählt;
   - einem zweiten Zähler (18), welcher an die Wähleinrichtung gekoppelt ist und eine Anzahl vorbestimmter Zeitschlitze zählt; und
   - mit einer Impulserzeugungseinrichtung zur Bildung der ganzzahligen Frequenz durch Erzeugen eines Impulses im Ansprechen auf ein Signal der Vergleichseinrichtung,

   **gekennzeichnet durch**
   eine Vergleichseinrichtung (20), welche den Wert des ersten Zählers mit der gewählten Teilerkonstanten vergleicht, wobei der zweite Zähler an die Vergleichseinrichtung (20) gekoppelt ist, und wobei der Speicher (24) mindestens drei erste und zweite Teilerkonstanten (g bzw. g+1) speichert.

2. Rationaler Frequenzteiler nach Anspruch 1, **dadurch gekennzeichnet,** **daß** der zweite Zähler innerhalb eines Zyklus von 1 bis n zählt, wobei n die Anzahl der vorbestimmten Zeitschlitze ist, die benötigt wird, um eine ganzzahlige Frequenz zu erzeugen, und **daß** die Teilerkonstanten so im Speicher (24) gespeichert sind, daß mindestens zweimal während eines Zyklus ein Wechsel zwischen den ersten und den zweiten Teilerkonstanten auftritt.

3. Rationaler Frequenzteiler nach Anspruch 2, **dadurch gekennzeichnet,** **daß** ein Zyklus mit einer ganzzahligen Teilerkonstanten begonnen wird, die der rationalen Zahl des Teilungsverhältnisses am nächsten liegt.

4. Rationaler Frequenzteiler nach einem der vorhergehenden Ansprüche, **dadurch gekennzeichnet,** **daß** Mittel zur Erzeugung einer ganzzahligen Frequenz aus einer rationalen Frequenz entsprechend der Beziehung

$$f_g = \frac{f_0}{g^{z/n}}$$

vorgesehen sind, wobei $f_g$ die ganzzahlige Frequenz, $f_0$ die rationale Frequenz, g eine erste Teilerkonstante, z einen Teilerkonstantenzähler und n die Anzahl von Zeitschlitzen darstellen und g, z und n natürliche Zahlen sind,

- der Speicher (24) Bereiche zur Speicherung von n-z ersten und z zweiten Teilerkonstanten g bzw. g+1 aufweist;
- die Wähleinrichtung (22) derart ausgebildet ist, daß während des Betriebs innerhalb eines Zyklus von n Zeitschlitzen die gespeicherten Teilerkonstanten jeweils einmal gewählt werden;
- der erste Zähler (16) derart ausgebildet ist, daß er im Ansprechen auf ein Signal der Vergleichseinrichtung, welches die Gleichheit des Werts des ersten Zählers mit der gewählten Teilerkonstanten anzeigt, auf den Wert 1 zurückgesetzt wird; und
- der zweite Zähler (18) derart ausgebildet ist, daß er im Ansprechen auf ein Signal der Vergleichseinrichtung, welches die Gleichheit des Werts des ersten Zählers mit der gewählten Teilerkonstanten anzeigt, um den Wert 1 erhöht und nach Erreichen des Werts von n auf 1 zurückgesetzt wird.

5. Verfahren zur Erzeugung einer ganzzahligen Frequenz aus einer rationalen Frequenz, mit den Schritten

a] Bestimmen und Abspeichern der Größen g, z, und n entsprechend der Beziehung

$$f_g = \frac{f_0}{g^{z/n}},$$

wobei $f_g$ die ganzzahlige Frequenz, $f_0$ die rationale Frequenz, g eine erste Teilerkonstante, z einen Teilerkonstantenzähler und n die Anzahl von Zeitschlitzen darstellen und g, z und n natürliche Zahlen sind, und der Größe g+1, welche eine zweite Teilerkonstante darstellt;

b] Initialisieren eines ersten Zählers (16), welcher im Takt der Schwingungen der rationalen Frequenz zählt, und eines zweiten Zählers (18), welcher die Zeitschlitze zählt, auf den Wert 1;

c] Wählen der ersten oder zweiten Teilerkonstante;

d] Zählen des ersten Zählers im Takt der Schwingungen der rationalen Frequenz;

e] Erfassen der Gleichheit des Werts des ersten Zählers und der gewählten Teilerkonstante;

f] Erzeugen eines Impulses auf das Erfassen der Gleichheit des Werts des ersten Zählers und der gewählten Teilerkonstante zur Bildung der ganzzahligen Frequenz;

g] Rücksetzen des ersten Zählers auf den Wert 1;

h] Erhöhen des zweiten Zählers um 1;

i] Wiederholen der Schritte c] bis h], wobei während eines Zyklus von n Zeitschlitzen [n-z]-mal die erste Teilerkonstante und z-mal die zweite Teilerkonstante gewählt wird; und

k] Rücksetzen des zweiten Zählers auf den Wert 1, nachdem der zweite Zähler den Wert von n erreicht hat und die Schritte c] bis g] n-mal ausgeführt worden sind.

**Claims**

1. Rational frequency divider for generating an integer frequency (fg) from a rational frequency ($f_0$), comprising

- a memory (24) for storing first and second divider constants (g and g+1, respectively);
- a selection device (22) for selecting one of the stored divider constants;
- a first counter (16) which counts in synchronism with the oscillations of the rational frequency;
- a second counter (18) which is coupled to the selection device and counts a number of predetermined time intervals; and
- comprising a pulse generating device for forming the integer frequency by generating a pulse in response to a signal of the comparison device,

**characterized by** a comparison device (20) which compares the value of the first counter with the selected divider constant, the second counter being coupled to the comparison device (20), and the memory (24) storing at least three first and second divider constants (g and g+1, respectively).

2. Rational frequency divider according to Claim 1, **characterized in that** the second counter counts from 1 to n within one cycle, n being the number of predetermined time intervals which is needed for generating an integer frequency, and **in that** the divider constants are stored in the memory (24) in such a manner that a change between the first and the second divider constants occurs at least twice during one cycle.

3. Rational frequency divider according to Claim 2, **characterized in that** a cycle is begun with an integral divider constant which is closest to the rational number of the dividing ratio.

4. Rational frequency divider according to one of the preceding claims, **characterized in that** means for generating an integer frequency from a rational frequency according to the relation

$$f_g = \frac{f_0}{g^{z/n}}$$

are provided, where $f_g$ is the integer frequency, $f_0$ is the rational frequency, g is a first divider constant, z is a divider constant counter and n is the number of time intervals and g, z and n are natural numbers,

- the memory (24) has areas for storing n-z first and z second divider constants g and g+1, respectively;
- the selection device (22) is constructed in such a manner that the stored divider constants are in each case selected once within one cycle of n time intervals during operation;
- the first counter (16) is constructed in such a manner that it is reset to the value 1 in response to a signal of the comparison device which indicates the equality of the value of the first counter with the selected divider constant; and
- the second counter (18) is constructed in such a manner that it is incremented by the value 1 and, after reaching the value of n, is reset to 1 in response to a signal of the comparison device which indicates the equality of the value of the first counter with the selected divider constant.

5. Method for generating an integer frequency from a rational frequency, comprising the following steps:

a] Determining and storing the quantities g, z and n in accordance with the relation

$$f_g = \frac{f_0}{g^{z/n}},$$

where $f_g$ is the integer frequency, $f_0$ is the rational frequency, g is a first divider constant, z is a divider constant counter and n is the number of time intervals and g, z and n are natural numbers, and the quantity g+1 which represents a second divider constant;
b] initializing a first counter (16) which counts in synchronism with the oscillations of the rational frequency, and a second counter (18) which counts the time intervals, to the value 1;

c] selecting the first or second divider constant;
d] counting the first counter in synchronism with the oscillations of the rational frequency;
e] detecting the equality of the value of the first counter and of the selected divider constant;
f] generating a pulse on the detection of the equality of the value of the first counter and of the selected divider constant for forming the integer frequency;
g] resetting the first counter to the value 1;
h] incrementing the second counter by 1;
i] repeating steps c] to h], the first divider constant being selected [n-z] times, and the second divider constant being selected z times, during a cycle of n time intervals; and
k] resetting the second counter to the value 1 after the second counter has reached the value of n and steps c] to g] have been performed n times.

## Revendications

1. Diviseur de fréquence rationnelle permettant de produire une fréquence entière ($f_g$) à partir d'une fréquence rationnelle ($f_0$), comprenant :

- une mémoire (24) pour enregistrer des premières et secondes constantes de diviseur (g resp. g+1) ;
- un dispositif de sélection (22) permettant de sélectionner une des constantes de diviseur enregistrées ;
- un premier compteur (16) qui compte dans la cadence des oscillations de la fréquence rationnelle ;
- un second compteur (18) qui est couplé au dispositif de sélection et compte un nombre d'intervalles de temps prédéterminés ; et
- un dispositif générateur d'impulsions permettant de former la fréquence entière grâce à la production d'une impulsion en réponse à un signal du dispositif comparateur,

**caractérisé par**
un dispositif comparateur (20) qui compare la valeur du premier compteur à la constante de diviseur sélectionnée, le second compteur étant couplé au dispositif comparateur (20),
et la mémoire (24) enregistrant au moins trois premières et secondes constantes de diviseur (g resp. g+1).

2. Diviseur de fréquence rationnelle selon la revendication 1,
**caractérisé en ce que** le second compteur compte à l'intérieur d'un cycle allant de 1 à n, n étant le nombre d'intervalles de temps prédéterminés nécessaire pour produire une fréquence entière,

et **en ce que** les constantes de diviseur sont enregistrées dans la mémoire (24) de manière à ce qu'un changement entre les premières et les secondes constantes de diviseur ait lieu au moins deux fois au cours d'un cycle.

3. Diviseur de fréquence rationnelle selon la revendication 2,
**caractérisé en ce qu'**un cycle commence avec une constante de diviseur entière la plus proche possible du nombre rationnel du rapport de division.

4. Diviseur de fréquence rationnelle selon l'une des revendications précédentes, **caractérisé en ce que** l'on prévoit un moyen pour produire une fréquence entière à partir d'une fréquence rationnelle suivant la relation

$$f_g = \frac{f_0}{g^{z/n}},$$

$f_g$ représentant la fréquence entière, $f_0$ la fréquence rationnelle, g une première constante de diviseur, z un compteur de constantes de diviseur et n le nombre d'intervalles de temps, et g, z et n étant des nombres naturels,

- la mémoire (24) comprend des zones pour enregistrer n-z premières et z secondes constantes de diviseur g resp. g+1 ;
- le dispositif de sélection (22) est exécuté de manière à ce que, pendant le fonctionnement, les constantes de diviseur enregistrées soient à chaque fois sélectionnées une fois à l'intérieur d'un cycle de n intervalles de temps ;
- le premier compteur (16) est exécuté de manière à être ramené à la valeur 1 en réponse à un signal du dispositif comparateur indiquant l'égalité entre la valeur du premier compteur et la constante de diviseur sélectionnée ; et
- le second compteur (18) est exécuté de manière à être augmenté de la valeur 1 et ramené à 1 une fois atteinte la valeur n, en réponse à un signal du dispositif comparateur indiquant l'égalité entre la valeur du premier compteur et la constante de diviseur sélectionnée.

5. Procédé pour produire une fréquence entière à partir d'une fréquence rationnelle, comprenant les étapes qui consistent à :

a] déterminer et mémoriser les grandeurs g, z et n correspondant à la relation

$$f_g = \frac{f_0}{g^{z/n}},$$

$f_g$ représentant la fréquence entière, $f_0$ la fréquence rationnelle, g une première constante de diviseur, z un compteur de constantes de diviseur et n le nombre d'intervalles de temps, et g, z et n étant des nombres naturels, et la grandeur g+1 qui représente une seconde constante de diviseur ;
b] initialiser sur la valeur 1 un premier compteur (16) qui compte dans la cadence des oscillations de la fréquence rationnelle et un second compteur (18) qui compte les intervalles de temps ;
c] sélectionner la première ou la seconde constante de diviseur ;
d] faire compter le premier compteur dans la cadence des oscillations de la fréquence rationnelle ;
e] saisir l'égalité entre la valeur du premier compteur et la constante de diviseur sélectionnée ;
f] produire une impulsion en réponse à la saisie de l'égalité entre la valeur du premier compteur et la constante de diviseur sélectionnée en vue de former la fréquence entière ;
g] ramener le premier compteur à la valeur 1 ;
h] augmenter le second compteur de 1 ;
i] répéter les étapes c] à h], la première constante de diviseur étant sélectionnée [n-z] fois et la seconde constante de diviseur z fois au cours d'un cycle de n intervalles de temps ; et
k] ramener le second compteur à la valeur 1 après que le second compteur a atteint la valeur n et que les étapes c] à g] ont été exécutées n fois.

**FIG 1**

rationaler Frequenz-generator  →  $f_0$  →  rationaler Frequenz-teiler  →  $f_g$  →  ganzzahliger Frequenz-teiler

12 — 10 — 14 —

**FIG 2**

Teilerkonstanten

16 — Zähler 1..g+1  $f_0$  →  Reset  →  $Q_z$  →  Vergleich  ←  $Q_k$  ←  Auswahl

1 ← g — 24
n-z ← g — 24
1 ← g+1 — 24
z ← g+1 — 24

= 

Select ↑

$f_g$ →  Zeitschlitz-zähler 1.. n — 18  =n Reset

**FIG 3**

Teilerkonstanten

16 — Zähler 1..3  $f_0$  →  Reset  →  $Q_z$  →  Vergleich  ←  $Q_k$  ←  Auswahl

1 ← 3 — 24
2 ← 2 — 24
3 ← 3 — 24

=

Select ↑

$f_g$ →  Zeitschlitz-zähler 1.. 3 — 18  =3 Reset

# FIG 4

EP 1 110 324 B1